# EUROPEAN PATENT APPLICATION

(11) **EP 4 815 635 A1**
(43) Date of publication of application: **30.09.2026**
(21) Application number: 24905629.2
(22) Date of filing: 30.08.2024
(51) Int. Cl.: H05K 1/02, H05K 7/20

(54) **DOUBLE-SIDED PACKAGE STRUCTURE, POWER SUPPLY APPARATUS AND ELECTRONIC DEVICE**

(30) Priority: 19.12.2023 CN 202311761950
(71) Applicant: Huawei Technologies Co., Ltd., Shenzhen, Guangdong 518129 (CN)
(72) Inventor: GENG, Yi, Shenzhen, Guangdong 518129 (CN); LV, Yatao, Shenzhen, Guangdong 518129 (CN); LIU, Wenbo, Shenzhen, Guangdong 518129 (CN); ZHANG, Xijun, Shenzhen, Guangdong 518129 (CN)
(74) Representative: MERH-IP Matias Erny Reichl Hoffmann Patentanwälte PartG mbB
(86) International application number: PCT/CN2024/115800
(87) International publication number: WO 2025/130136

(57) **Abstract**

A double-sided package structure, a power supply apparatus, and an electronic device are disclosed. Power devices are disposed on two side board surfaces of a PCB substrate of the double-sided package structure. A thermally conductive member is inserted into the PCB substrate and packaged to form a package body. The package body includes a heat dissipation surface, and the heat dissipation surface is opposite to one side board surface of the PCB substrate. The PCB substrate has a via and a through hole that are connected to each other through a copper foil, the via is connected to at least a power device disposed on the other side board surface of the PCB substrate, the thermally conductive member is inserted into the through hole, and one end of the thermally conductive member extends to the heat dissipation surface of the package body. In this way, for a power device on a non-heat-dissipation surface side, heat may be dissipated in sequence through a low-thermal-resistance heat dissipation path that is formed by the via, the copper foil, the through hole, and the thermally conductive member, effectively improving heat dissipation performance of the power device on the non-heat-dissipation surface side. In addition, based on the structural characteristic of the inserted thermally conductive member, the package width can be reduced, thereby meeting the trend requirements for a high-density layout.

## Description

This application claims priority to Chinese Patent Application No. 202311761950.1, filed with the China National Intellectual Property Administration on December 19, 2023 and entitled "DOUBLE-SIDED PACKAGE STRUCTURE, POWER SUPPLY APPARATUS, AND ELECTRONIC DEVICE", which is incorporated herein by reference in its entirety.

### TECHNICAL FIELD

Embodiments of this application relate to the field of electronic component packaging technologies, and in particular, to a double-sided package structure, a power supply apparatus, and an electronic device.

### BACKGROUND

For a double-sided package structure, heat generated during operation of an internal power device needs to be dissipated in a timely manner to meet the requirements of actual output performance. With the development trend of miniaturization, integration, and high power consumption of devices, the heat dissipation environment of devices is facing a development bottleneck.

To meet a functional requirement for a high-density layout, power devices of a system-in-package (System-in-Package, SiP) evolve from a single-sided layout to a double-sided layout. To be specific, power devices are disposed on two side board surfaces of a package printed circuit board (Printed Circuit Board, PCB). In addition, a good heat dissipation environment is required, to properly balance good performance of the SiP module and the requirement for a high-density layout. One side of the double-sided package structure close to a heat dissipation apparatus is a heat dissipation surface, and the other side of the double-sided package structure away from the heat dissipation apparatus is a non-heat-dissipation surface. A power device on the heat dissipation surface side has a shorter heat dissipation path, and a power device on the non-heat-dissipation surface side has a longer heat dissipation path. This results in a poor heat dissipation capability. When heat inside the SiP module cannot be dissipated in a timely manner, overall performance improvement of the SiP module is affected.

### SUMMARY

Embodiments of this application provide a double-sided package structure, a power supply apparatus, and an electronic device, to improve heat dissipation performance of the double-sided package structure by optimizing the double-sided package structure.

A first aspect of embodiments of this application provides a double-sided package structure. The double-sided package structure includes a PCB substrate, power devices, and a thermally conductive member. The power devices are disposed on two side board surfaces of the PCB substrate, and the thermally conductive member is inserted into the PCB substrate and packaged to form a package body. The package body includes a heat dissipation surface, and the heat dissipation surface is opposite to one side board surface of the PCB substrate. The PCB substrate has a via and a through hole, and the via and the through hole are connected to each other through a copper foil on the PCB substrate. The via is connected to at least a power device disposed on the other side board surface of the PCB substrate, the thermally conductive member is inserted into the through hole, and one end of the thermally conductive member extends to the heat dissipation surface of the package body.

In this way, the power device on the other side board surface of the PCB substrate, namely, a power device on a non-heat-dissipation surface side, is away from the heat dissipation surface. For the power device on the non-heat-dissipation surface side, heat generated during operation of the power device can be dissipated to the heat dissipation surface after passing through a first heat dissipation path formed by the via, the copper foil, the through hole, and the thermally conductive member. In addition, the through hole, the copper foil, and the thermally conductive member on the PCB board all have good heat conduction capabilities, and the heat dissipation path formed has a low thermal resistance. In other words, a heat dissipation path with a low thermal resistance is formed between the non-heat-dissipation surface side and the heat dissipation surface of the double-sided package structure, thereby sufficiently utilizing a heat dissipation capability of the heat dissipation apparatus, and effectively improving heat dissipation performance of the power device on the non-heat-dissipation surface side. In addition, a power device on a side on which the heat dissipation surface of the double-sided package structure is located has a shorter heat dissipation path from the heat dissipation apparatus, thereby dissipating heat reliably.

In general, heat generated during operation of the power devices on both sides can be quickly dissipated, and the heat dissipation performance can be effectively improved. In a high power consumption application scenario, a power SiP is used as an example. Based on a double-sided package structure with good heat dissipation performance, a component over-temperature caused by heat accumulation can be avoided, an actual output capability of the power SiP can be ensured, and impact of derated output on product performance improvement can be effectively overcome.

In addition, in this embodiment, the thermally conductive member is disposed through insertion, and the thermally conductive member is supported and positioned by using a hole wall of the through hole in the PCB substrate. A thermally conductive member with a small cross-sectional size also has good pre-mounting stability. This can reduce occupied board space to a specific extent, thereby reducing a package width, and meeting a trend requirement for a high-density layout.

In addition, based on the good pre-mounting stability of the thermally conductive member, for a package body with a large thickness size, a height size of the thermally conductive member may be determined according to an overall layout requirement of an actual product. In addition, based on the efficient heat dissipation path formed by the thermally conductive member, a thickness of the package body is not increased while a heat dissipation capability on the non-heat-dissipation surface side is improved. The thermally conductive member can be widely used in package bodies of different thickness sizes, and has good structural universality.

During an actual application, the heat dissipation surface of the package body may be in direct contact with the heat dissipation apparatus for heat exchange, or may be in indirect contact with the heat dissipation apparatus for heat exchange through an intermediate structure. For example, but not limited to, the heat dissipation surface of the package body may be in direct contact with the heat dissipation apparatus for heat exchange through a thermal adhesive.

For example, the thermally conductive member may be a rotating body, or may be in another shape that meets a functional requirement.

Based on the first aspect, an embodiment of this application further provides a first implementation of the first aspect: The power devices located on the two side board surfaces of the PCB substrate are both connected to the via. In other words, heat from the power device located on the heat dissipation surface side may also be dissipated to the heat dissipation surface after passing through the heat dissipation path formed by the via, the copper foil, the through hole, and the thermally conductive member, thereby sufficiently utilizing the formed heat dissipation path with a low thermal resistance and implementing multi-path efficient heat dissipation.

For example, the power device may be connected to one via, or may be connected to a plurality of vias.

In addition, for example, the via may be connected to one layer of copper foil, or may be connected to a plurality of layers of copper foil.

For another example, the copper foil may be connected to one through hole, or may be connected to a plurality of through holes.

Based on the first aspect or the first implementation of the first aspect, an embodiment of this application further provides a second implementation of the first aspect: Two surfaces that are opposite to each other and a side surface of the package body are covered with a metal layer, the metal layer includes a surface metal layer located on the surfaces of the package body and a side metal layer located on the side surface of the package body, and the side metal layer is separately connected to the two surface metal layers; and an end portion of the thermally conductive member is connected to a surface metal layer on a side on which the end portion of thermally conductive member is located. In this way, a heat conduction path from the heat dissipation surface side to the non-heat-dissipation surface side is established by using the metal layer. For the power device on the non-heat-dissipation surface side, the heat generated during operation of the power device may further be transferred to the surface metal layer located on the heat dissipation surface side after sequentially passing through the surface metal layer on the non-heat-dissipation surface side and the side metal layer, thereby sufficiently utilizing a heat dissipation capability of the heat dissipation apparatus. A second heat dissipation path formed by the metal layer on the surface of the package body is used to synchronously and quickly dissipate heat of the power device on non-heat-dissipation surface side.

Based on the second implementation of the first aspect, an embodiment of this application further provides a third implementation of the first aspect: The surface metal layer of the metal layer is patterned to form a pin of the double-sided package structure. In this way, the thermally conductive member may further lead an electrical signal of the PCB substrate to the surface of the package body, and connect to a system board or a power supply backplane through the functional pin formed by patterning the surface metal layer on the side surface. In other words, the heat dissipation path with a low thermal resistance also has a function of through-current, for example, but not limited to communication or power supply, and meets a trend design requirement for a high-density layout.

During an actual application, when no metal layer is covered on the surface of the package body, the thermally conductive member may also be directly used as a functional pin of the double-sided package structure, to transmit a signal.

Based on the first aspect, or the first implementation of the first aspect, or the second implementation of the first aspect, or the third implementation of the first aspect, an embodiment of this application further provides a fourth implementation of the first aspect: In an insertion direction, the other end of the thermally conductive member extends to a non-heat-dissipation surface of the package body, and the non-heat-dissipation surface and the heat dissipation surface are the two surfaces that are opposite to each other of the package body. In this way, a bidirectional heat conduction capability can be obtained based on the thermally conductive member.

Based on the first aspect, or the first implementation of the first aspect, or the second implementation of the first aspect, or the third implementation of the first aspect, or the fourth implementation of the first aspect, an embodiment of this application further provides a fifth implementation of the first aspect: The through hole includes a large-aperture section and a small-aperture section that are connected to each other, and the thermally conductive member is inserted into the large-aperture section of the through hole, to implement heat dissipation and through-current. The thermally conductive member does not penetrate the other side of the PCB substrate, so that a board area occupied by the side can be reduced, and more electronic components can be disposed to increase a layout density. In addition, based on the disposition of the small-aperture section, in a PCB electroplating and reflow soldering process, air may be exhausted through the small-aperture section. For example, in a process of copper plating on a side wall of the through hole, this facilitates exchange of an electroplating solution, and avoids affecting quality of electroplating of a large-sized buried via due to poor exchange of the electroplating solution at the bottom of a blind via (reducing a board area occupied by the thermally conductive member). For another example, during reflow soldering, a solder flux may be discharged through the small-aperture section after volatilization, thereby avoiding squeezing solder paste due to gas expansion and volatilization, and effectively ensuring a product yield rate.

According to the first aspect, or the first implementation of the first aspect, or the second implementation of the first aspect, or the third implementation of the first aspect, or the fourth implementation of the first aspect, or the fifth implementation of the first aspect, an embodiment of this application further provides a sixth implementation of the first aspect: The thermally conductive member includes a small-sized section and a large-sized section that are connected to each other, and there is a step surface between the small-sized section and the large-sized section; and the small-sized section is inserted into the through hole of the PCB substrate, and the step surface abuts against a board surface of the PCB substrate. In this way, based on an abutting adaptation relationship between the step surface and the board surface, the thermally conductive member may be assembled and positioned while inserted into the PCB substrate, so that the thermally conductive member maintains a pre-mounting angle with the PCB substrate, for example, but not limited to being approximately perpendicular, thereby avoiding tilting of the thermally conductive member before the thermally conductive member is fastened, and effectively ensuring a product yield rate.

Based on the sixth implementation of the first aspect, an embodiment of this application further provides a seventh implementation of the first aspect: A plurality of small-sized sections are spaced apart on the large-sized section of the thermally conductive member. During an actual application, each small-sized section separately fits a corresponding through hole through insertion, so that a heat conduction capability can be effectively enhanced. In addition, a plurality of small-sized sections that fit the PCB substrate can be placed in one assembly operation, pre-mounting stability is further improved, and assembly processability is good.

During an actual application, the large-sized section of the thermally conductive member may be in a long bar shape, and the plurality of small-sized sections are sequentially spaced apart in an extension direction of the large-sized section in the long bar shape. For example, the large-sized section may be in a straight bar shape, or may be in a wavy long bar shape.

During another actual application, the large-sized section of the thermally conductive member may alternatively be in a bent shape, and the plurality of small-sized sections are sequentially spaced apart in a bending direction of the large-sized section in the bent shape. For example, the large-sized section may be approximately right-angled, or may be determined based on an actual board surface layout, to provide a good heat dissipation capability for the power device while considering an original function layout of the product, thereby achieving good adaptability.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, an eighth implementation of the first aspect is further provided in this embodiment of this application: The power device includes a field-effect transistor. During an actual application, the double-sided package structure further includes a plurality of electronic components, at least one of the plurality of electronic components is a capacitor element or a resistor element, and the electronic component is disposed on at least one side board surface of the PCB substrate.

A second aspect of embodiments of this application provides a power supply apparatus. The power supply apparatus includes a system board, a power supply system-in-package module, and a heat dissipation apparatus. The power supply system-in-package module is prepared by using the foregoing double-sided package structure, and is soldered to the system board. The heat dissipation apparatus is in contact with another side of the power supply system-in-package module for heat exchange. In general, multi-path enhanced heat dissipation based on the double-sided package structure can effectively alleviate an over-temperature bottleneck of a power SiP device, and provide technical assurance for enhancing a power density and efficiency.

A third aspect of embodiments of this application provides another power supply apparatus. The power supply apparatus includes a system board, a power supply backplane, a power supply system-in-package module, and a heat dissipation apparatus, the power supply system-in-package module is prepared by using the foregoing double-sided package structure, and is soldered to the power supply backplane, the heat dissipation apparatus and the power supply backplane are located on a same side, and the heat dissipation apparatus is in contact with the power supply system-in-package module for heat exchange. During an actual application, an over-temperature bottleneck of a power SiP device can also be effectively alleviated, and technical assurance is provided for enhancing a power density and efficiency.

A fourth aspect of embodiments of this application provides an electronic device. The electronic device includes a mainboard and the foregoing power supply apparatus, and the power supply apparatus is disposed on the mainboard.

For example, the heat dissipation apparatus may be a finned air-cooled heat sink. For another example, the heat dissipation apparatus may alternatively be a liquid-cooled cold plate heat sink.

### BRIEF DESCRIPTION OF DRAWINGS

FIG. 1 is a sectional view of a double-sided package structure according to an embodiment of this application;
FIG. 2 is a diagram of a use state of the double-sided package structure shown in FIG. 1;
FIG. 3 is a diagram of another use state of the double-sided package structure shown in FIG. 1;
FIG. 4 is a diagram of a structure of a thermally conductive member according to an embodiment of this application;
FIG. 5 is a diagram of a structure of another thermally conductive member according to an embodiment of this application;
FIG. 6 is a diagram of a structure of another thermally conductive member according to an embodiment of this application;
FIG. 7 is a diagram of a structure of another thermally conductive member according to an embodiment of this application;
FIG. 8 is a sectional view of another double-sided package structure according to an embodiment of this application;
FIG. 9 is a diagram of a use state of the double-sided package structure shown in FIG. 8;
FIG. 10 is a diagram of an assembly process of the double-sided package structure shown in FIG. 8;
FIG. 11 is a sectional view of still another double-sided package structure according to an embodiment of this application;
FIG. 12 is a diagram of a use state of the double-sided package structure shown in FIG. 11;
FIG. 13 is a diagram of an electronic device according to an embodiment of this application;
FIG. 14 is a diagram of an architecture of a power supply apparatus according to an embodiment of this application; and
FIG. 15 is a diagram of an architecture of another power supply apparatus according to an embodiment of this application.

### DESCRIPTION OF EMBODIMENTS

Embodiments of this application provide a double-sided package structure implementation solution, to be applied to different high power consumption scenarios.

With the development of the SiP (System in Package, system in package) technology, power devices evolve from a single-sided layout to a double-sided layout, to be applied to small-sized, integrated, and high-power consumption application scenarios. A power supply system-in-package (System in Package, SiP) module is used as an example. Field-effect transistors (Metal Oxide Semiconductor Field Effect Transistors, MOSFETs or MOSs for short) of a power SiP are disposed on two side board surfaces of a packaged PCB, to form a double-sided package structure. The MOS in the power SiP generates a large amount of heat, and therefore requires a good heat dissipation capability. In addition to the MOS, the power SiP may further include electronic components such as a resistor and/or a capacitor.

With innovation of a circuit architecture, a power supply module of a vertical power supply architecture has a high power supply density. Correspondingly, a position relationship between the power SiP and a high-temperature load chip is increasingly close, and a heat dissipation environment faces a development bottleneck. If heat generated inside cannot be taken away in a timely manner, a component over-temperature is caused due to heat accumulation. In this case, the power SiP implements derated output to ensure performance and a service life. For example, a 1600 W packaged power supply apparatus can implement full-power output at a temperature lower than 60°C, and the output power decreases to 1200 W at 70°C. It can be determined that a heat dissipation capability of the package structure directly affects continuous improvement of a power density.

For the power SiP module, a MOS located on a non-heat-dissipation surface side has a longer heat dissipation path from a heat dissipation apparatus. Timely and effective heat dissipation of heat generated by the MOS on this side has become one of the focuses to ensure heat dissipation performance of the package structure. Therefore, for the non-heat-dissipation surface side of the double-sided package structure, a solution that can effectively dissipate heat generated by a component needs to be provided, to prevent a high temperature from affecting improvement of product performance.

In view of this, an embodiment of this application provides a double-sided package structure. The double-sided package structure includes a PCB substrate, power devices, and a thermally conductive member. The PCB substrate includes a first board surface and a second board surface that are opposite to each other. The power devices are disposed on both the first board surface and the second board surface. The thermally conductive member is inserted into the PCB substrate and is packaged to form a package body. The "packaging" herein means that the PCB substrate and the power device are sealed by using a packaging filling material to form a package body with a determined structure form. For example, but not limited to, the power device may be a MOS of a power SiP module. In another possible implementation, electronic components such as a capacitor, a resistor, an inductor, or an integrated circuit (integrated circuit, IC) may also be packaged and disposed on the two side board surfaces of the PCB substrate.

The package body includes a heat dissipation surface, and the heat dissipation surface is opposite to one side board surface (for example, the first board surface) of the PCB substrate, and is configured to be in contact with a heat dissipation apparatus side for heat exchange. The side on which the heat dissipation surface is located is the side on which a heat dissipation surface of the double-sided package structure is located, and the other side opposite to the heat dissipation surface is a side on which a non-heat-dissipation surface of the double-sided package structure is located. Herein, the heat dissipation surface of the package body may be in direct contact with a heat dissipation apparatus for heat exchange, or may be in indirect contact with the heat dissipation apparatus for heat exchange through an intermediate structure. For example, but not limited to, the heat dissipation surface of the package body may be in direct contact with the heat dissipation apparatus for heat exchange through a thermal adhesive.

The PCB substrate has a via and a through hole, the via and the through hole are connected to each other through a copper foil on the PCB substrate, the via is connected to at least a power device disposed on the other side board surface (for example, the second board surface) of the PCB substrate, the thermally conductive member is inserted into the through hole of the PCB substrate, and one end of the thermally conductive member extends to the heat dissipation surface of the package body.

In this way, for the power device on the other side board surface of the double-sided package structure, heat generated during operation of the power device can be dissipated to the heat dissipation surface after sequentially passing through a heat dissipation path formed by the via, the copper foil, the through hole, and the thermally conductive member. In addition, the through hole, the copper foil, and the thermally conductive member on the PCB board all have good heat conduction capabilities, and the heat dissipation path formed has a low thermal resistance. In other words, a heat dissipation path with a low thermal resistance is formed between the non-heat-dissipation surface side and the heat dissipation surface side of the double-sided package structure, thereby sufficiently utilizing a heat dissipation capability of the heat dissipation apparatus, and effectively improving heat dissipation performance of the power device on the non-heat-dissipation surface side. In addition, the power device on the first board surface of the double-sided package structure is located on a side on which the heat dissipation surface is located, and has a shorter heat dissipation path from the heat dissipation apparatus, thereby dissipating heat reliably.

In general, heat generated during operation of the power devices on both sides can quickly dissipated, and the heat dissipation performance can be effectively improved. In a high power consumption application scenario, based on a double-sided package structure with good heat dissipation performance, a component over-temperature caused by heat accumulation can be avoided, an actual output capability of the power SiP can be ensured, and impact of derated output on product performance improvement can be effectively overcome.

In addition, in this embodiment, the thermally conductive member is disposed through insertion, and the thermally conductive member is supported and positioned by using a hole wall of the through hole in the PCB substrate. A thermally conductive member with a small cross-sectional size also has good pre-mounting stability. This can reduce occupied board space to a specific extent, thereby reducing a package width, and meeting a trend requirement for a high-density layout.

In addition, based on the good pre-mounting stability of the thermally conductive member, for a package body with a large thickness size, a height size of the thermally conductive member may be determined according to an overall layout requirement of an actual product. In addition, based on the efficient heat dissipation path formed by the thermally conductive member, a thickness of the package body is not increased while a heat dissipation capability on the non-heat-dissipation surface side is improved. The thermally conductive member can be widely used in package bodies of different thickness sizes, and has good structural universality.

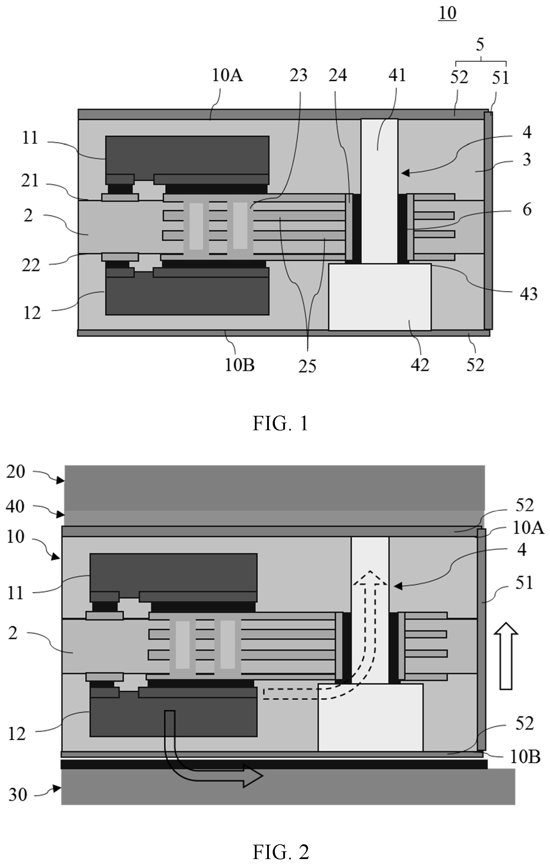

To better understand the technical solutions and technical effects of this application, without loss of generality, the following describes specific embodiments in detail with reference to the accompanying drawings by using a power SiP as a description object. FIG. 1 is a sectional view of a double-sided package structure according to an embodiment of this application.

As shown in FIG. 1, the double-sided package structure 10 is a power SiP module. As shown in the figure, a first MOS 11 is disposed on a first board surface 21 of a PCB substrate 2, and a second MOS 12 is disposed on a second board surface 22 of the PCB substrate 2. For ease of description, other electronic components in the power SiP are not shown in the figure, for example, but not limited to, power devices such as a capacitor, a resistor, or an inductor.

A via 23 and a through hole 24 that are spaced apart in the PCB substrate 2 are connected to each other through a copper foil 25. In specific implementation, the copper foil 25 may be an intermediate copper foil layer, or may be a surface copper foil layer, and may be formed by different hole forming processes, to implement a reliable connection between the via 23 and the copper foil 25 and between the through hole 24 and the copper foil 25.

In specific implementation, the via 23 configured to connect to a MOS may be a through hole shown in the figure. In another possible implementation, the via 23 may alternatively be of another via type, for example, a buried via or a blind via, to implement the foregoing connection relationship. This is not limited in this embodiment of this application.

MOSs disposed on the two side board surfaces of the PCB substrate 2 are all connected to the via 23, and heat is transferred to the through hole 24 by using the copper foil 25. In specific implementation, each MOS may be connected to one or more vias 23, and a plurality of vias 23 are used to achieve higher heat transfer efficiency. (One or more) vias 23 provided corresponding to one MOS may be connected to one layer of copper foil 25 or may be connected to a plurality of layers of copper foil 25. The plurality of layers of copper foil 25 are used to achieve higher heat transfer efficiency. Similarly, one layer of copper foil 25 or a plurality of layers of copper foil 25 may be connected to one through hole 24 or a plurality of through holes 24. Based on the thermally conductive member 4 that adapts to the plurality of through holes 24, heat transfer efficiency is further improved. In another possible implementation, in terms of PCB copper on a heat dissipation path, a quantity of configured vias 23, copper foils 25, and through holes 24 may be randomly selected according to an actual requirement.

The first MOS 11 located on the first board surface 21 and the second MOS 12 located on the second board surface 22 may be connected to a same through hole through a same via and copper foil layer, and heat generated during operation of each MOS is transferred to the through hole side through a path with a low thermal resistance. In a possible implementation, each MOS may alternatively be connected to different through holes through different vias and copper foil layers, provided that a heat dissipation path with a low thermal resistance can be obtained. This is not limited in embodiments of this application.

Specifically, on the basis of not affecting function implementation of the board surface of the PCB substrate 2, a spacing between the via 23 and the through hole 24 may be as small as possible, to shorten a heat dissipation path of a to-be-heat-dissipated MOS (power device), and further optimize a heat dissipation capability.

In specific implementation, MOSs located on the two side board surfaces of the PCB substrate 2 may be interconnected through the PCB substrate according to a function configuration requirement. This may be specifically implemented by using the conventional technology, and details are not described herein again.

It may be understood that a quantity of MOSs disposed in the double-sided package structure 10 may be determined according to an overall product design. For example, but not limited thereto, four, six, or other a plurality of MOSs may be configured. The plurality of MOSs may be respectively disposed on two opposite board surfaces of the PCB substrate 2, and are packaged into a package body by using a packaging filler 3. Herein, the packaging filler 3 may be a resin filling material. This is not limited in embodiments of this application.

The thermally conductive member 4 of the double-sided package structure 10 is inserted into the PCB substrate 2. In an insertion direction, the thermally conductive member 4 is of a variable cross-sectional structure, and includes a small-sized section 41 and a large-sized section 42 that are connected to each other, and there is a step surface 43 between the small-sized section 41 and the large-sized section 42.

The small-sized section 41 of the thermally conductive member 4 is inserted into the through hole 24 of the PCB substrate 2, and extends out of the first board surface 21. The thermally conductive member 4 may be in contact with the through hole 24 through the small-sized section 41, to transfer heat. The large-sized section 42 of the thermally conductive member 4 is located on a side of the second board surface 22, and the step surface 43 abuts against the second board surface 22. In this way, based on an abutting adaptation relationship between the step surface 43 and the second board surface 22, assembly positioning may be formed when the thermally conductive member 4 is inserted into the PCB substrate 2, so that the thermally conductive member 4 maintains a pre-mounting angle with the PCB substrate 2, for example, but not limited to, approximately perpendicular to the PCB substrate 2 shown in the figure, to prevent the thermally conductive member 4 from falling down relative to the PCB substrate 2 before being fastened, and effectively ensure a product yield rate. It should be understood that the "small-sized section" and the "large-sized section" herein are used to describe a size relationship of a variable cross-sectional structure of the thermally conductive member 4, but are not used to refer to a specific structural size. In addition, the step surface 43 is a transition structure surface between the "small-sized section" and the "large-sized section". A form of the step surface may be determined based on a hole forming process, and is not limited to a plane perpendicular to an axis of the through hole.

In addition, the thermally conductive member 4 is inserted into a hole, and a hole wall of the via 23 in the PCB substrate 2 may support the thermally conductive member 4. In this way, the thermally conductive member 4 with a small cross-sectional size also has relatively good pre-mounting stability. In comparison with a conventional heat dissipation manner in which a surface-mounted copper pillar is used on a board surface, the copper pillar needs a specific cross-sectional size to be stably attached to a surface of the PCB, especially, the cross-sectional size of the copper pillar needs to be correspondingly increased with an increase in a height size of the copper pillar to avoid instability and falling. For a double-sided package structure with a same heat dissipation parameter, when the thermally conductive member 4 is inserted into a hole, the thermally conductive member 4 with a small cross-sectional size can reduce occupied board space, and a package width can be properly controlled.

In addition, assembly positioning implemented based on the step surface 43 can reduce, to a specific extent, a processing precision requirement of the thermally conductive member 4 and the through hole 24. On the basis of ensuring a product yield rate, product processing costs can be properly controlled.

In specific implementation, the thermally conductive member 4 inserted into the through hole 24 may be assembled and fastened by using a through hole reflow soldering process. Specifically, tin may be printed near the through hole 24, and the thermally conductive member 4 may be inserted into the hole and soldered together with another surface-mounted component on the PCB substrate 2 by using a reflow oven. The thermally conductive member 4 and the through hole 24 are fastened by using soldering tin 6, and no additional process is required. The process route is simple and the process costs are controllable.

Still as shown in FIG. 1, in the insertion direction, two extended ends of the thermally conductive member 4 are respectively located on a surface of the package body on a side on which the two extended ends are located, that is, penetrate the package body (the PCB substrate and a package material), one end extends to a heat dissipation surface of the package body, and the other end extends to a non-heat-dissipation surface, opposite to the heat dissipation surface, of the package body, so as to reduce a thermal resistance of a heat dissipation path. In other words, the small-sized section 41 of the thermally conductive member 4 extends to a first surface 10A of the package body, and the large-sized section 42 of the thermally conductive member 4 extends to a second surface 10B of the package body. The first surface 10A of the package body and the first board surface 21 of the PCB substrate 2 are located on a same side, and the second surface 10B of the package body and the second board surface 22 of the PCB substrate 2 are located on a same side. Therefore, the thermally conductive member 4 can transfer heat to two opposite surfaces of the package body, and can select, according to a configuration requirement of an actual application scenario, one of the two opposite surfaces to be in contact with the heat dissipation apparatus side for heat exchange.

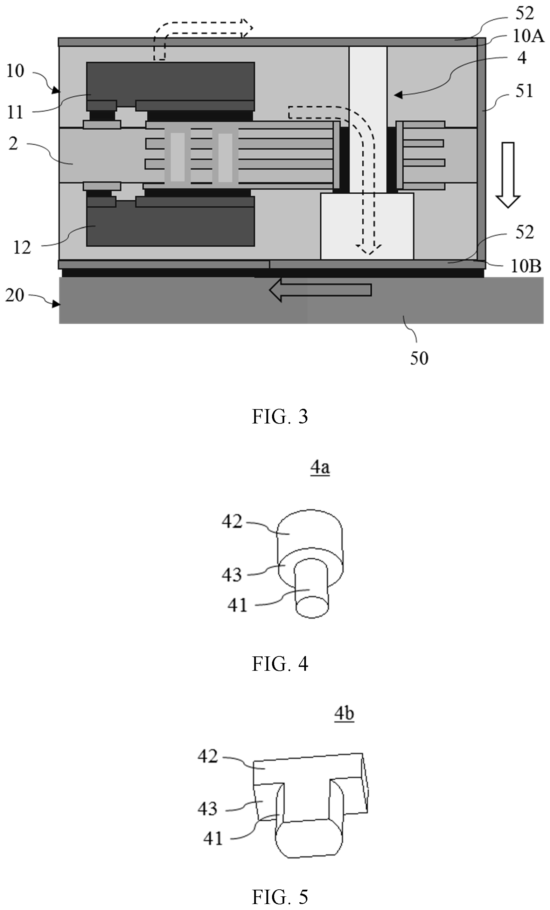

Herein, the first surface 10A and the second surface 10B are two surfaces that are opposite to each other of the package body. In different use states, one of the surfaces is a heat dissipation surface close to the heat dissipation apparatus, and the other is a non-heat-dissipation surface away from the heat dissipation apparatus. Refer to FIG. 2 and FIG. 3 together. FIG. 2 and FIG. 3 respectively show two different use states of the double-sided package structure 10 shown in FIG. 1.

In a specific implementation, as shown in FIG. 2, the double-sided package structure 10 is soldered to a system board 30, a pin is located on the second surface 10B of the package body, and a soldering surface of the package body is located on a side on which the second surface 10B is located. The heat dissipation apparatus 20 is disposed on a side of the first surface 10A of the package body and is in contact for heat exchange, and the heat dissipation surface of the package body is located on a side on which the first surface 10A is located. In other words, the soldering surface and the heat dissipation surface are respectively located on two sides of the package body. In the double-sided package structure 10 shown in FIG. 2, the first MOS 11 disposed on the first board surface is a power device on the heat dissipation surface side, and the second MOS 12 disposed on the second board surface is a power device on the non-heat-dissipation surface side.

For the second MOS 12 on the non-heat-dissipation surface side, heat generated during operation of the second MOS 12 may be transferred to a through hole side through a via and a copper foil on the PCB substrate 2. Specifically, as shown by a dashed arrow indicating a heat conduction direction in FIG. 2, the heat is transferred to the heat dissipation apparatus 20 through the thermally conductive member 4. In this way, a heat dissipation capability of the heat dissipation apparatus 20 is fully utilized to form a first heat dissipation path with a low thermal resistance: PCB copper (the via 23, the copper foil 25, and the through hole 24) → the thermally conductive member 4 → the heat dissipation apparatus 20, thereby quickly dissipating heat of the power device on the non-heat-dissipation surface side.

In specific implementation, a structure form of the heat dissipation apparatus 20 may be determined according to a configuration requirement of an application scenario, for example, but not limited to a heat dissipation cold plate. To improve heat conduction efficiency, the heat dissipation apparatus 20 may be in contact with the heat dissipation surface side of the double-sided package structure 10 for heat exchange by using a heat conducting medium 40. For example, but not limited to, the heat conducting medium 40 may be a thermal adhesive, and a gap is filled during heat conduction, so that an absolute thermal resistance of the heat dissipation structure can be reduced, and heat dissipation with a low thermal resistance and high thermal conductivity can be implemented.

In another possible implementation, the heat dissipation apparatus 20 may use a liquid cooling heat dissipation structure, or may be an air cooling heat dissipation structure. This is not limited in this embodiment of this application.

As shown in FIG. 1 and FIG. 2, to further improve a heat dissipation capability of the double-sided package structure 10, optionally, the first surface 10A, the second surface 10B, and a side surface of the package body are all covered with a metal layer 5. A side metal layer 51 located on the side surface is separately connected to a surface metal layer 52 located on the first surface 10A and the second surface 10B, to establish a heat conduction path from the heat dissipation surface side to the non-heat-dissipation surface side by using the metal layer 5.

For the second MOS 12 on the non-heat-dissipation surface side, heat generated during operation of the second MOS 12 may be further transferred to the surface metal layer 52 on the first surface 10A through the surface metal layer 52 located on the second surface 10B and the side metal layer 51 in sequence. Specifically, as shown by a solid arrow indicating a heat conduction direction in FIG. 2, a heat dissipation capability of the heat dissipation apparatus 20 is fully utilized, with a second heat dissipation path formed by the metal layer 5 on the surface of the package body: the surface metal layer 52 → the side metal layer 51 → the heat dissipation apparatus 20, to synchronously and quickly dissipate heat of the power device on the non-heat-dissipation surface side.

In addition, the surface metal layer 52 located on the first surface 10A and the second surface 10B is separately in contact with the small-sized section 41 and the large-sized section 42 of the thermally conductive member 4 for heat exchange. The metal layer 5 forms a continuous heat conduction path for conducting heat to one side of the heat dissipation apparatus 20 or to one side of the system board 30, thereby equalizing heat, conducting heat, and dissipating heat from the thermally conductive member 4. In general, multi-path enhanced heat dissipation based on the double-sided package structure 10 can effectively alleviate an over-temperature bottleneck of a power SiP device, and provide technical assurance for enhancing a power density and efficiency.

A temperature simulation test is performed by a heat dissipation solution in which a surface-mounted copper pillar is used on a non-heat-dissipation surface side as a comparative example. In a same test scenario, when the double-sided package structure 10 described in FIG. 1 is used, a MOS temperature on the non-heat-dissipation surface side can be reduced by approximately 25°C, and a heat dissipation enhancement effect is significant.

In specific implementation, the metal layer 5 may be formed through surface deposition, for example, but not limited to, may be a solderable metal coating like a copper layer.

Further, as shown in FIG. 1 and FIG. 2, the thermally conductive member 4 located on the first heat dissipation path may further have a signal transmission function.

The thermally conductive member 4 may be soldered to the through hole 24 of the PCB substrate 2, and the large-sized section 42 of the thermally conductive member 4 extends to the second surface 10B of the package body and is in contact with the surface metal layer 52 on the side of the second surface 10B for heat exchange. In addition, the surface metal layer 52 on the side of the second surface 10B may be patterned to form a pin on a soldering surface of the double-sided package structure 10, and a function of the pin is implemented through the connected large-sized section 42. In other words, the thermally conductive member 4 may further lead an electrical signal of the PCB substrate 2 to the surface of the package body and connect to the surface metal layer 52. The patterned surface metal layer 52 is connected to the system board 30 as a functional pin of the double-sided package structure 10.

Certainly, when the surface of the package body is not covered with a metal layer, the large-sized section 42 may also be directly used as a functional pin of the double-sided package structure 10, and is configured to transmit a signal, for example, but not limited to communication or power supply.

In another specific implementation, as shown in FIG. 3, the double-sided package structure 10 is soldered to a power supply backplane 50, a pin is located on the second surface 10B of the package body, and a soldering surface of the package body is located on a side on which the second surface 10B is located. The heat dissipation apparatus 20 is disposed on a side of the second surface 10B of the package body and is in contact for heat exchange, and the heat dissipation surface of the package body is located on a side on which the second surface 10B is located. In other words, the soldering surface and the heat dissipation surface are located on a same side of the package body. In the double-sided package structure 10 shown in FIG. 3, the first MOS 11 disposed on the first board surface is a power device on the non-heat-dissipation surface side, and the second MOS 12 disposed on the second board surface is a power device on the heat dissipation surface side.

For the first MOS 11 on the non-heat-dissipation surface side, heat generated during operation of the first MOS 11 may be transferred to a through hole side through a via and a copper foil on the PCB substrate 2. Specifically, as shown by a dashed arrow indicating a heat conduction direction in FIG. 3, the heat is transferred to the heat dissipation apparatus 20 through the thermally conductive member 4. In this way, a heat dissipation capability of the heat dissipation apparatus 20 is fully utilized to form a first heat dissipation path with a low thermal resistance, to quickly dissipate heat of the power device on the non-heat-dissipation surface side.

For the first MOS 11 on the non-heat-dissipation surface side, heat generated during operation of the first MOS 11 may be further transferred to the surface metal layer 52 on the second surface 10B through the surface metal layer 52 located on the first surface 10A and the side metal layer 51 in sequence. Specifically, as shown by a solid arrow indicating a heat conduction direction in FIG. 3, a heat dissipation capability of the heat dissipation apparatus 20 is fully utilized, with a second heat dissipation path formed by the metal layer 5 on the surface of the package body, to synchronously and quickly dissipate heat of the power device on the non-heat-dissipation surface side.

It should be noted that, in the implementation described in FIG. 1, the MOSs (power devices) disposed on the two board surfaces of the PCB substrate 2 are all connected to the vias. In another possible implementation, only the MOS on the non-heat-dissipation surface side may be connected to the via (not shown in the figure), and a reliable heat dissipation path is provided for the power device on the non-heat-dissipation surface side of the double-sided package structure. In other words, the MOS away from the side on which the heat dissipation apparatus is located passes through a low thermal resistance path formed by the via, the copper foil, and the through hole. For example, the first board surface 21 of the package body is close to the heat dissipation apparatus, and the second MOS 12 on the second board surface 22 is connected to the via. For another example, the second board surface 22 of the package body is close to the heat dissipation apparatus, and the first MOS 11 on the first board surface 21 is connected to the via.

Optionally, another electronic component (not shown in the figure) is further integrated and packaged in the double-sided package structure 10. For example, but not limited to, the electronic component may be a resistor and/or a capacitor disposed on the PCB substrate 2, to achieve a corresponding function according to an overall design requirement of a module. In addition to the MOS, other electronic components that generate a large amount of heat may also be used as power devices and correspondingly configured with vias (not shown in the figure). Heat generated during operation of the electronic components is transferred to a corresponding thermally conductive member through PCB copper (vias, copper foil, and through holes).

For the columnar thermally conductive member 4 with a variable cross section, different structural forms may be used in specific implementation.

FIG. 4 is a diagram of a structure of a thermally conductive member according to an embodiment of this application. As shown in FIG. 4, a thermally conductive member 4a is a rotating body, both a small-sized section 41 and a large-sized section 42 are of a rotating body structure, and a step surface 43 is formed between the small-sized section 41 and the large-sized section 42. The small-sized section 41 is configured to be inserted into a through hole 24 of a PCB substrate 2 to form a heat dissipation path, and the step surface 43 is configured to abut against a board surface of the PCB substrate to form assembly positioning.

FIG. 5 is a diagram of a structure of another thermally conductive member according to an embodiment of this application. As shown in FIG. 5, a large-sized section 42 of a thermally conductive member 4b is cuboid, and a small-sized section 41 is a columnar body with an irregular cross section. Similarly, a step surface 43 is formed between the large-sized section 42 and the small-sized section 41.

The thermally conductive members described in FIG. 4 and FIG. 5 each include a small-sized section. To improve the heat conduction capability and operability, optionally, the thermally conductive member may further include a plurality of small-sized sections.

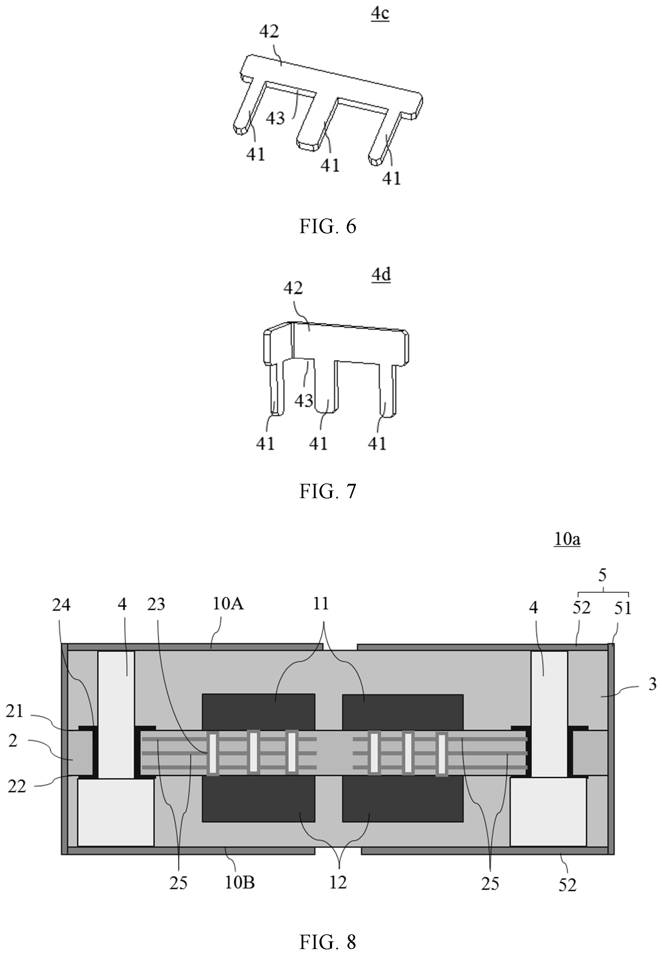

FIG. 6 is a diagram of a structure of another thermally conductive member according to an embodiment of this application. As shown in FIG. 6, a large-sized section 42 of a thermally conductive member 4c is in a long bar shape. Three small-sized sections 41 are spaced apart on the long bar-shaped large-sized section 42, and each small-sized section 41 may be respectively inserted into three through holes 24 (not shown in the figure) of a PCB substrate 2. In another implementation, a plurality of other small-sized sections 41 may be disposed on the large-sized section 42. This is not limited in this embodiment of this application.

In this way, a structural form in which a plurality of small-sized sections are disposed on the large-sized section 42 can effectively enhance a heat conduction capability. In addition, a plurality of small-sized sections 41 that adapt to the PCB substrate 2 can be placed in one operation, pre-mounting stability can be further improved, and assembly processability can be good.

It should be noted that the long bar-shaped large-sized section 42 is not limited to the straight bar shape shown in the figure. In an actual application scenario, avoidance may be performed based on an actual board surface layout, for example, the long bar-shaped large-sized section 42 is not limited to a wavy long bar shape.

FIG. 7 is a diagram of a structure of another thermally conductive member according to an embodiment of this application. As shown in FIG. 7, a large-sized section 42 of a thermally conductive member 4d is bent. Three small-sized sections 41 are spaced apart on the bent large-sized section 42, and each small-sized section 41 may be respectively inserted into three through holes 24 (not shown in the figure) of a PCB substrate 2. In another implementation, a plurality of other small-sized sections 41 may be disposed on the large-sized section 42. This is not limited in this embodiment of this application.

It should also be noted that the bent large-sized section 42 is not limited to an approximately right-angled shape shown in the figure. In an actual application scenario, the bent large-sized section 42 may be determined based on an actual board surface layout, so as to provide a good heat dissipation capability for a power device while considering an original function layout of a product, thereby achieving good adaptability.

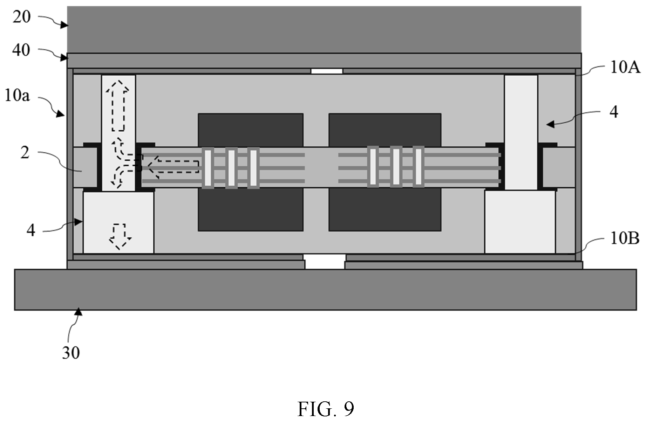

For a MOS to be heat-dissipated in a double-sided package structure 10, a specific quantity and disposition positions of thermally conductive members 4 may be correspondingly set based on a layout of the power device. Refer to FIG. 8 and FIG. 9. FIG. 8 is a sectional view of another double-sided package structure according to an embodiment of this application, and FIG. 9 is a diagram of a use state of the double-sided package structure shown in FIG. 8. To clearly show a difference and a relationship between this implementation solution and the solution described in FIG. 1, components or structures with a same function are indicated by a same reference sign in the figures.

Compared with the double-sided package structure described in FIG. 1, the double-sided package structure 10a shown in FIG. 8 has two first MOSs 11, two second MOSs 12, and two thermally conductive members 4. It should be understood that FIG. 8 is a sectional view of the double-sided package structure 10a, and an increase in a quantity of components such as the first MOS 11, the second MOS 12, and the thermally conductive member 4 is not limited to a quantity shown in the sectional view.

As shown in FIG. 9, the double-sided package structure 10a is soldered to a system board 30. Based on the thermally conductive member 4, the PCB copper (via, copper foil, and through hole), and the metal layer 5, two continuous heat conduction paths shown by dashed arrows in the figure are formed. Heat is transferred to one side of the heat dissipation apparatus 20 through one path, and is transferred to one side of the system board 30 through the other path, thereby equalizing heat, conducting heat, and dissipating heat from the thermally conductive member 4. In specific implementation, an overall layout of the double-sided package structure 10a may be determined based on different application scenarios. This is not limited in this embodiment of this application.

Other compositions and implementations of the double-sided package structure 10a may be the same as those in the solution described in FIG. 1. Therefore, details are not described again.

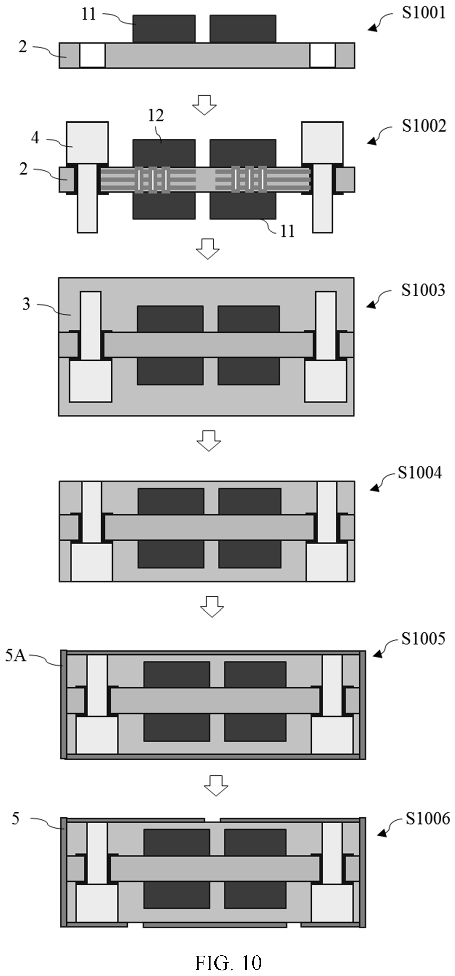

The following briefly describes an assembly process of the double-sided package structure 10a with reference to FIG. 10 by using the double-sided package structure shown in FIG. 8 as an example.

Step S601: Assemble the first MOS 11 on the first board surface 21 of the PCB substrate 2. For example, but not limited thereto, the foregoing components may be assembled and fastened by using an SMT (Surface Mount Technology, surface mount technology) process.

Step S602: Assemble the second MOS 12 and the thermally conductive member 4 on the second board surface 22 of the PCB substrate 2. Similarly, the foregoing assembly and fastening may be completed by using SMT.

Step S603: Form a package body through double-sided packaging, and fill all spacings or gaps between the first MOS 11, the second MOS 12, the thermally conductive member 4, and the PCB substrate 2 based on the packaging filler 3. The PCB substrate 2 is integrally coupled with the first MOS 11, the second MOS 12, the thermally conductive member 4, and other components.

Step S604: Grind the plastic package body, and expose two ends of the thermally conductive member 4 on two side surfaces of the package body. In other words, the two extended ends of the thermally conductive member 4 are respectively located on the surfaces of the package body on the corresponding sides by using a grinding process.

Step S605: Metalize a surface of the package body.

In specific implementation, a metallization process may be used, so that a continuous metal coating 5A is formed by depositing a surface and a side wall of the package body, and an end face of the thermally conductive member 4.

Step S606: Form a metal layer 5 through patterning.

In specific implementation, through a patterning process and surface processing, a metal coating is formed into a solderable expected pattern. The metal layer 5 formed through patterning may be used as a continuous heat conduction path, and a metal coating pattern may be used as a pin of the double-sided package structure 10.

It should be understood that step S604 is an optional step. In another possible implementation solution, precision of a packaging process may ensure that the extended end of the thermally conductive member 4 is located on the surface of the package body on a side on which the extended end is located.

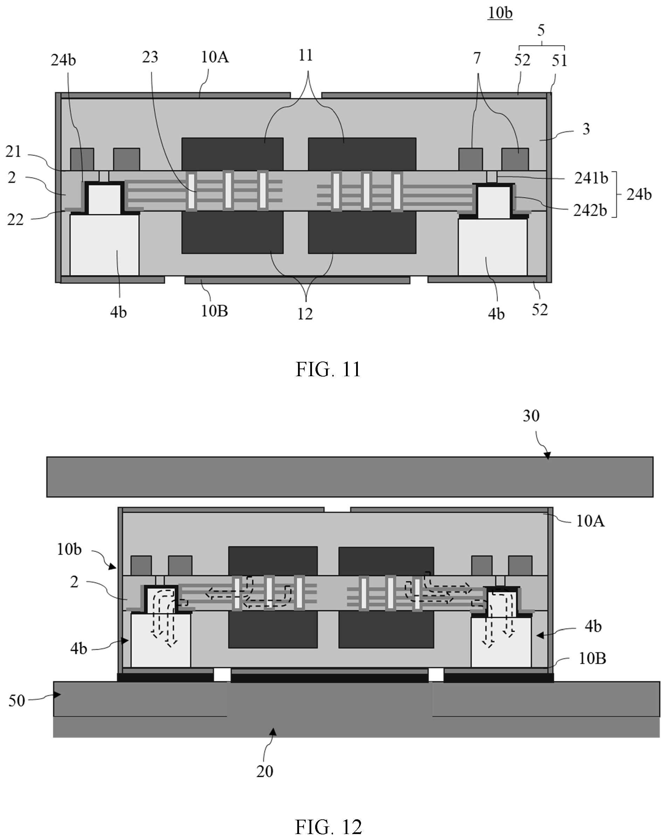

In the foregoing implementation solution, both the two outer extended ends of the thermally conductive member extend to the surface of the package body on a side on which the extended ends are located. In another implementation, only one end of the thermally conductive member may alternatively extend to the heat dissipation surface of the package body. Refer to FIG. 11 and FIG. 12. FIG. 11 is a sectional view of still another double-sided package structure according to an embodiment of this application, and FIG. 12 is a diagram of a use state of the double-sided package structure shown in FIG. 11. To clearly show a difference and a relationship between this implementation solution and the solution described in FIG. 1 and FIG. 8, components or structures with a same function are indicated by a same reference sign in the figures.

As shown in FIG. 11, a double-sided package structure 10b may also be a power SiP module. MOSs are disposed on both side board surfaces of the PCB substrate 2, a first MOS 11 is disposed on a first board surface 21 of the PCB substrate 2, and a second MOS 12 is disposed on a second board surface 22 of the PCB substrate 2.

A via 23 and a through hole 24b that are spaced apart in the PCB substrate 2 are connected to each other through a copper foil 25. In specific implementation, the copper foil 25 may be an intermediate copper foil layer. MOSs disposed on the two side board surfaces of the PCB substrate 2 are all connected to the via 23, and heat is transferred to the through hole 24 by using the copper foil 25.

In this implementation solution, the through hole 24b is a stepped hole, and includes a large-aperture section 241b and a small-aperture section 242b that are connected to each other. The large-aperture section 241b is close to the first board surface 21, and the thermally conductive member 4b is inserted into the large-aperture section 241b of the through hole 24b, to implement heat dissipation and through-current. The small-aperture section is close to the second board surface 22. Herein, the thermally conductive member 4b does not penetrate a side on which the second board surface 22 is located, so that an occupied board area can be reduced, more electronic components 7 can be arranged on the second board surface 22, and a layout density is increased.

In addition, in a PCB electroplating and reflow soldering process, air may be exhausted through the small-aperture section 242b. For example, in a process of copper plating on a side wall of the through hole, this facilitates exchange of an electroplating solution, and avoids affecting quality of electroplating of a large-sized buried via due to poor exchange of the electroplating solution at the bottom of a blind via (reducing a board area occupied by the thermally conductive member). For another example, during reflow soldering, a solder flux may be discharged through the small-aperture section after volatilization, thereby avoiding squeezing solder paste due to gas expansion and volatilization, and avoiding a possibility that a soldering yield is affected as solder paste is not bonded to the thermally conductive member.

In an insertion direction, the thermally conductive member 4b is of a variable cross-sectional structure, and includes a small-sized section 41 and a large-sized section 42 that are connected to each other, and there is a step surface 43 between the small-sized section 41 and the large-sized section 42. When the thermally conductive member 4 is inserted into the PCB substrate 2, assembly positioning is formed, so that the thermally conductive member 4 maintains a pre-mounting angle with the PCB substrate 2, and also has good pre-mounting stability.

As shown in FIG. 12, the double-sided package structure 10b is soldered to the power supply backplane 50. The first MOS 11 disposed on the first board surface is a power device on a non-heat-dissipation surface side, and the second MOS 12 disposed on the second board surface is a power device on a heat dissipation surface side. A heat dissipation path of the power device (the first MOS) formed on the non-heat-dissipation surface side based on the thermally conductive member 4b, the PCB copper (the via, the copper foil, and the through hole), and the metal layer 5 is shown by a dashed arrow in the figure.

It may be understood that, the power device (the second MOS) on the heat dissipation surface side may also dissipate heat based on the thermally conductive member 4b, the PCB copper, and the metal layer 5, and is not explicitly shown in the figure for clarity of illustrating the heat dissipation path on the non-heat-dissipation surface side.

Other compositions and implementations of the double-sided package structure 10b may be the same as those in the solution described in FIG. 1 and FIG. 8. Therefore, details are not described again.

A temperature simulation test is performed by a heat dissipation solution in which a surface-mounted copper pillar is used on a non-heat-dissipation surface side as a comparative example. In a same test scenario, when the surface-mounted copper pillar solution in the comparative example is used, a temperature of the MOS on the non-heat-dissipation surface side reaches 125°C, which cannot meet a thermal derating requirement of a product. When the double-sided package structure 10b described in FIG. 11 is used, heat generated during operation of each MOS is transferred to the thermally conductive member 4b through the PCB copper, and then efficiently transferred to the heat dissipation apparatus 20 through the thermally conductive member 4b. In this case, a temperature gain on the non-heat-dissipation surface side is 6.5°C, and a temperature gain on the heat dissipation surface side is 8°C, so that a heat dissipation enhancement effect is significant.

In addition, the implementation in which the thermally conductive member is inserted into the through hole through penetration is used as a comparative example. The double-sided package structure 10b described in FIG. 11 is used, and the through hole 24b in the PCB substrate uses a large-and-small hole structure, so that a board area occupied by the non-heat-dissipation surface side can be reduced by 85%, and a layout area gain is significant.

In the foregoing implementation solution, the thermally conductive member 4 is of a variable cross-sectional structure in the insertion direction, to provide support and positioning through a step surface. In another possible implementation, the thermally conductive member may alternatively be of an equal cross-sectional structure, for example, but not limited to a cylindrical shape (not shown in the figure), and a heat dissipation path with a low thermal resistance can also be obtained. This is not limited in this embodiment of this application.

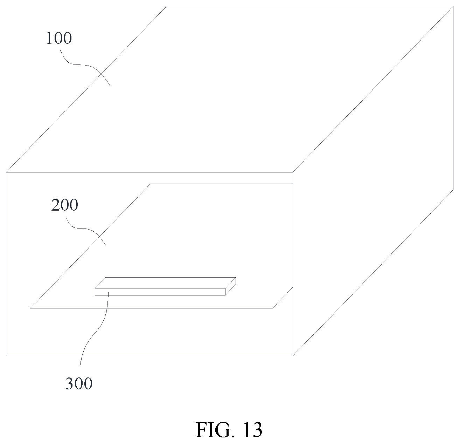

The implementation solutions of the double-sided package structure described in the foregoing embodiments may be widely applied to different electronic devices including a power device to be dissipated. FIG. 13 is a diagram of an electronic device according to an embodiment of this application.

As shown in FIG. 13, the electronic device includes a housing 100, a mainboard 200 disposed in the housing 100, and a power supply apparatus 300. The power supply apparatus 300 is electrically connected to the mainboard 200, and is configured to supply power to the mainboard and a power device on the mainboard. The power supply apparatus 300 includes a power supply system-in-package module, and the power supply system-in-package module may be the double-sided package structure described in the foregoing embodiments.

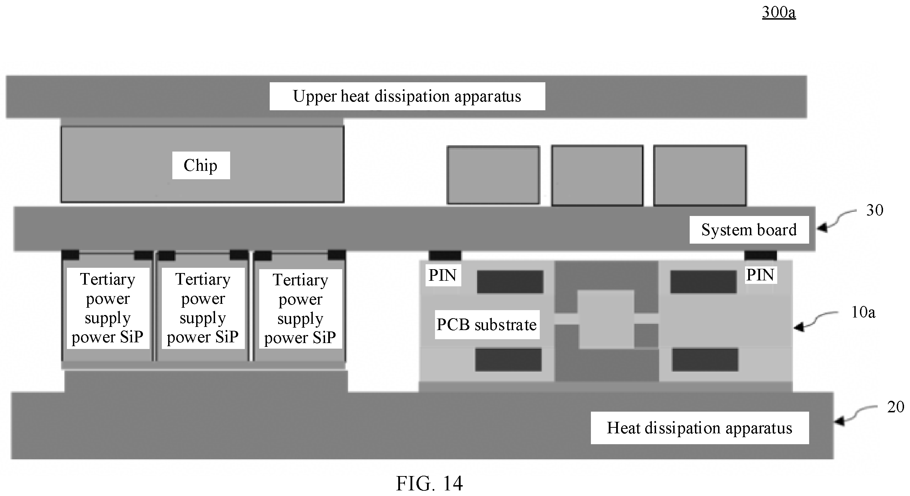

FIG. 14 is a diagram of a structure of a power supply apparatus 300a according to an embodiment of this application.

The power supply apparatus 300a includes a system board 30, a power supply system-in-package module 10a, and a heat dissipation apparatus 20. The power supply system-in-package module 10a is prepared by using the double-sided package structure described in FIG. 1 to FIG. 12, and is soldered to the system board 30. The heat dissipation apparatus 20 is in contact with another side of the power supply system-in-package module 10a for heat exchange.

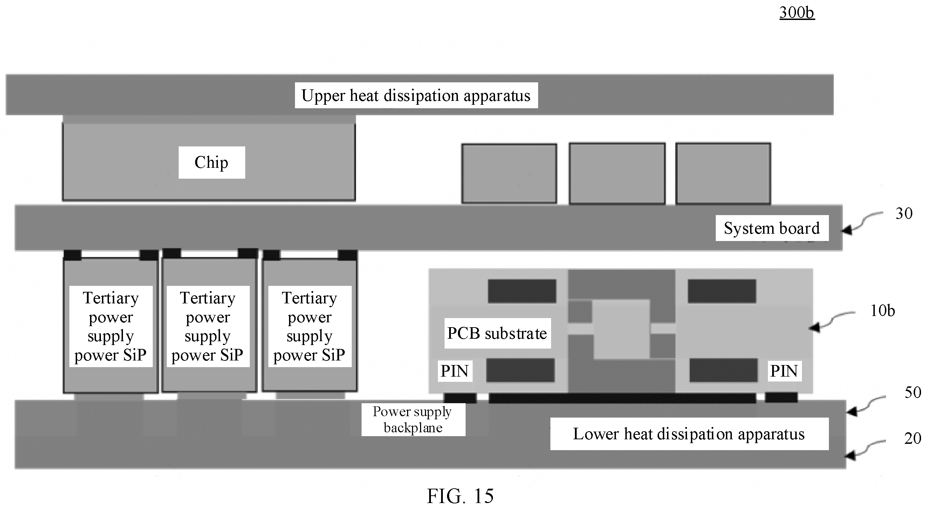

FIG. 15 is a diagram of a structure of another power supply apparatus 300b according to an embodiment of this application.

The power supply apparatus 300b includes a system board 30, a power supply backplane 50, a power supply system-in-package module 10b, and a heat dissipation apparatus 20. The power supply system-in-package module 10b is prepared by using the double-sided package structure described in FIG. 1 to FIG. 12, and is soldered to the power supply backplane 50. The heat dissipation apparatus 20 and the power supply backplane 50 are located on a same side, and the heat dissipation apparatus 20 is in contact with the power supply system-in-package module 10b for heat exchange.

Certainly, the power supply apparatus 300a and the power supply apparatus 300b further include a chip and a tertiary power supply power SiP. In addition, to obtain a better heat dissipation capability, a heat dissipation apparatus is further disposed on a chip side. The foregoing other functional components may be implemented by using the conventional technology. Therefore, details are not described herein again.

In specific implementation, the electronic device may be a smartphone, a smart television, a smart television set-top box, a personal computer (personal computer, PC), a wearable device, a smart broadband, or the like. This is not limited in this embodiment of this application. Based on the double-sided package structure provided in embodiments of this application, heat generated by a power device on a non-heat-dissipation surface side can be quickly dissipated, to provide a good ambient temperature, thereby improving product performance and ensuring stable and reliable running of the electronic device.

It should be understood that other main functional components of the electronic device may be implemented by using the conventional technology. Therefore, details are not described herein again.

It should be noted that, in an actual application scenario, a heat dissipation apparatus corresponding to a heat dissipation surface of a power supply module may be a finned air-cooled heat sink, or may be a liquid-cooled cold plate heat sink. Alternatively, a heat dissipation surface of a power supply module is exposed to an application environment. In other words, the heat dissipation surface side of the package body directly exchanges heat with air. This is not limited in this embodiment of this application.

The foregoing descriptions are merely example implementations of the present invention. It should be noted that a person of ordinary skill in the art may further make several improvements and modifications without departing from the principle of the present invention, and the improvements and modifications shall be considered as falling within the protection scope of the present invention.

## Claims

1. A double-sided package structure, comprising a PCB substrate, power devices, and a thermally conductive member, wherein the power devices are disposed on two side board surfaces of the PCB substrate, the thermally conductive member is inserted into the PCB substrate and packaged to form a package body, the package body comprises a heat dissipation surface, and the heat dissipation surface is opposite to one side board surface of the PCB substrate; and
the PCB substrate has a via and a through hole, and the via and the through hole are connected to each other through a copper foil on the PCB substrate, wherein
the via is connected to at least power device disposed on the other side board surface of the PCB substrate, the thermally conductive member is inserted into the through hole, and one end of the thermally conductive member extends to the heat dissipation surface of the package body.

2. The double-sided package structure according to claim 1, wherein the power devices located on the two side board surfaces of the PCB substrate are both connected to the via.

3. The double-sided package structure according to claim 1 or 2, wherein the power device is connected to one or more vias.

4. The double-sided package structure according to any one of claims 1 to 3, wherein the via is connected to one or more layers of copper foil.

5. The double-sided package structure according to any one of claims 1 to 4, wherein the copper foil is connected to one or more through holes.

6. The double-sided package structure according to any one of claims 1 to 5, wherein two surfaces that are opposite to each other and a side surface of the package body are covered with a metal layer, the metal layer comprises a surface metal layer located on the surfaces of the package body and a side metal layer located on the side surface of the package body, and the side metal layer is separately connected to the two surface metal layers; and an end portion of the thermally conductive member is connected to surface metal layer on a side on which the end portion of thermally conductive member is located.

7. The double-sided package structure according to claim 6, wherein the surface metal layer of the metal layer is patterned to form a pin of the double-sided package structure.

8. The double-sided package structure according to any one of claims 1 to 7, wherein in an insertion direction, the other end of the thermally conductive member extends to a non-heat-dissipation surface of the package body, and the non-heat-dissipation surface and the heat dissipation surface are the two surfaces that are opposite to each other of the package body.

9. The double-sided package structure according to any one of claims 1 to 7, wherein the through hole comprises a large-aperture section and a small-aperture section that are connected to each other, and the thermally conductive member is inserted into the large-aperture section of the through hole.

10. The double-sided package structure according to any one of claims 1 to 9, wherein the thermally conductive member comprises a small-sized section and a large-sized section that are connected to each other, and there is a step surface between the small-sized section and the large-sized section; and the small-sized section is inserted into the through hole of the PCB substrate, and the step surface abuts against a board surface of the PCB substrate.

11. The double-sided package structure according to claim 10, wherein a plurality of small-sized sections are spaced apart on the large-sized section.

12. The double-sided package structure according to claim 11, wherein the large-sized section is in a long bar shape or a bent shape.

13. The double-sided package structure according to any one of claims 1 to 12, wherein the power device comprises a field-effect transistor.

14. The double-sided package structure according to any one of claims 1 to 13, wherein the double-sided package structure further comprises a plurality of electronic components; and at least one of the plurality of electronic components is a capacitor element or a resistor element, and is disposed on at least one side board surface of the PCB substrate.

15. A power supply apparatus, wherein the power supply apparatus comprises a system board, a power supply system-in-package module, and a heat dissipation apparatus, the power supply system-in-package module is prepared by using the double-sided package structure according to any one of claims 1 to 14, and is soldered to the system board, and the heat dissipation apparatus is in contact with another side of the power supply system-in-package module for heat exchange.

16. A power supply apparatus, wherein the power supply apparatus comprises a system board, a power supply backplane, a power supply system-in-package module, and a heat dissipation apparatus, the power supply system-in-package module is prepared by using the double-sided package structure according to any one of claims 1 to 14, and is soldered to the power supply backplane, the heat dissipation apparatus and the power supply backplane are located on a same side, and the heat dissipation apparatus is in contact with the power supply system-in-package module for heat exchange.

17. An electronic device, comprising a mainboard and the power supply apparatus according to claim 15 or 16, wherein the power supply apparatus is disposed on the mainboard.
